# EUROPEAN PATENT APPLICATION

(11) **EP 4 730 610 A1**
(43) Date of publication of application: **22.04.2026**
(21) Application number: 24938146.8
(22) Date of filing: 17.05.2024
(51) Int. Cl.: H02J 13/00, G01R 31/00, H02H 7/26, H02B 1/24, H02B 15/00, H02B 99/00, G06N 20/00, G06N 3/0464, G05B 19/00, G05B 19/04

(54) **SYSTEM FOR VIRTUALISING THE CENTRALISER CABINET IN SINGLE-PHASE TRANSFORMER BANKS AND/OR SINGLE-PHASE REACTOR BANKS OF DIGITAL SUBSTATIONS, METHOD FOR MONITORING AND SWITCHING DEFECTIVE PHASES, METHOD FOR TRAINING A NEURAL NETWORK FOR MONITORING AND SWITCHING DEFECTIVE PHASES, AND CORRESPONDING COMPUTER-READABLE MEMORY**

(71) Applicant: Weg Equipamentos Elétricos S.A., 89.256-900 Jaraguá do Sul, SC (BR)
(72) Inventor: NETO, Carlos de Souza Moraes, 89012-130 Blumenau, SC (BR); OLESKOWICZ, Bruno Alexandre, 89053-316 Blumenau, SC (BR); SCHEFFER, Rafael Bonet, 89035-600 Blumenau, SC (BR)
(74) Representative: van Dam, Vincent
(86) International application number: PCT/BR2024/050201
(87) International publication number: WO 2025/236055

(57) **Abstract**

The present invention relates to a centralizing cabinet virtualization system in single-phase transformer banks and single-phase reactors of digital substations, wherein the virtualization implies the elimination of the physical centralizing cabinet by means of the arrangement of MUs within the phase control cabinets of the respective equipment. The present invention also relates to a computer-implemented method of monitoring and switching faulted phases (A, B, C) of single-phase transformers and/or single-phase reactors of the digital substation without manual human intervention. The present invention also relates to a computer-implemented method for training a neural network for monitoring normal or abnormal operating conditions of the phases (A, B, C) of transformer banks and/or reactor banks and also to computer-readable memories containing a set of instructions that, when executed, perform the faulted phase monitoring and switching method in a digital substation.

## Description

### Field of application

The present invention belongs to the field of circuit arrangements and systems for the supply or distribution of electrical energy, more specifically to the supervision of devices, systems, and methods for the operation and monitoring of electrical substations for the transformation of electrical current and electrical potential. Finally, the present invention also relates to the field of computer-implemented arrangements based on machine learning.

### Introduction

The present invention relates to a centralizing cabinet virtualization system in single-phase transformer banks and single-phase reactors of digital substations, wherein the virtualization implies the elimination of the physical centralizing cabinet by means of the arrangement of MUs within the phase control cabinets of the respective equipment.

The present invention also relates to a faulted phase monitoring and switching method of single-phase transformers and/or single-phase reactors of the digital substation without manual human intervention.

The present invention further relates to a method for training a neural network for monitoring normal or abnormal operating conditions of the phases of transformer banks and/or reactor banks and also to computer-readable memories containing a set of instructions that, when executed, perform the faulted phase monitoring and switching method in a digital substation.

### Background of the Invention

The Protection, Control, and Supervision Systems (PACS) of electrical substations are being improved, undergoing a revolution in data acquisition and availability techniques and, due to the digitalization or virtualization of one or more components of the substations, these new and modern substations are also called digital substations.

The electrical substations of the nature dealt with here are, preferably, but without limiting the invention, energy generation, distribution, generation, transmission, storage, industrial and fixed and/or mobile substations with SKIDs of all types, especially digital substations comprising a digital transformer and/or digital reactor, and these equipment may be of the three-phase type, when the phase windings are installed in the same tank, or of the single-phase type, when each winding is installed in a tank, forming a single-phase equipment bank. It should be noted that, in the case of single-phase equipment, there may be one or more backup phases, depending on the importance of the substation and/or the number of transformer and reactor banks installed.

In three-phase transformers and reactors, all signals for protection, control and supervision are available on terminals in the respective control cabinet. When they are single-phase, the signals from each phase are also available on terminals in the respective control cabinet, but they are concentrated in the so-called centralizing cabinets, which receive the signals from all the phases that make up that bank plus the backup phase, if any. In all these cases, the IEDs installed in the control room or command house receive these signals through command cables.

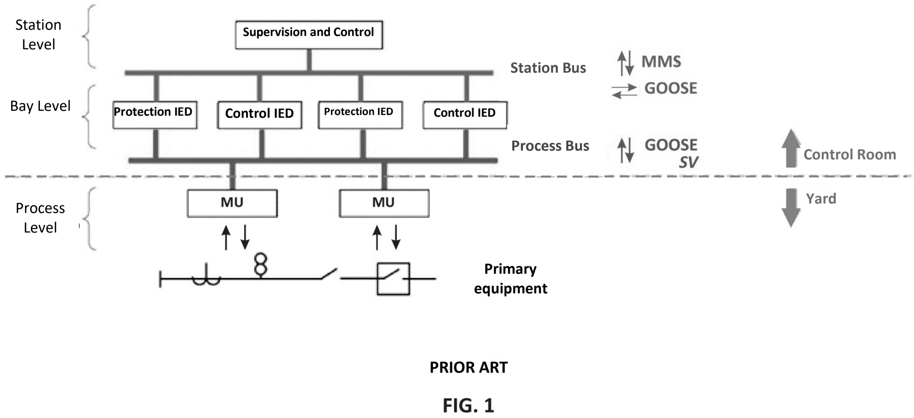

Digital substations essentially comprise primary equipment and MUs at process or yard level, IEDs and/or CPRs and/or VPRs for control and protection at process or bay level and supervision and control equipment at station level. The equipment at the yard level are connected to the equipment at the process level by the so-called process bus, while the equipment at the process level are connected to both the process bus and the equipment at the station level by the so-called station bus, which can be seen, as specifically illustrated in the attached Figure 1.

In current solutions known in the prior art, the station bus, represented by the blue line in the attached Figure 1, through which communication protocols circulate between IEDs and/or CPRs and/or VPRs, by means of GOOSE messages and between IEDs and the supervisory system, by means of MMS messages. These protocols are defined in the IEC-61850-8-1 standard.

The process bus, represented by the red line in the attached Figure 1, circulates GOOSE protocols (IEC-61850-8-1 standard) and Sampled Values or SVs (IEC-61850-9, IEC-61950-9-2LE and IEC-61869-9 standards), in addition to the PTP time synchronization protocol (defined in IEC-61588 and IEC-61850-9-3 standards) of IEDs, CPRs, VPRs and MUs.

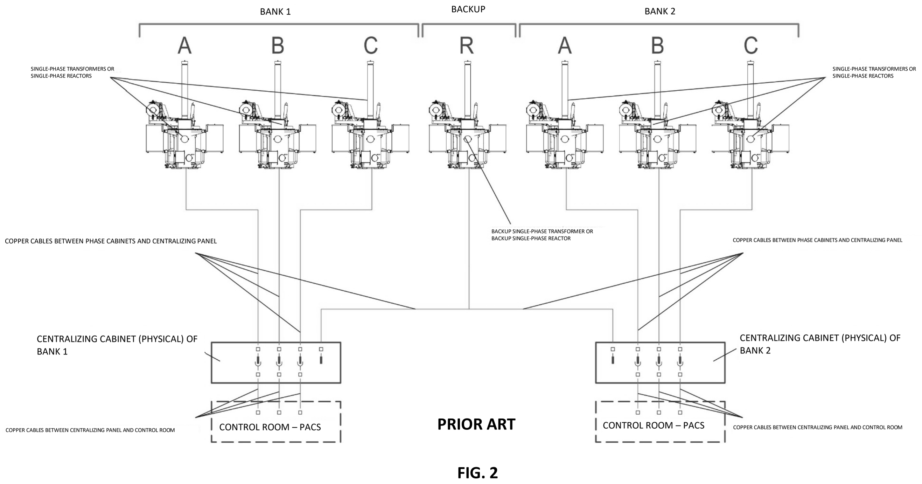

The design of a transformer bank in a substation essentially comprises the drawing of the phase control cabinet (typical drawings for all phases, including the backup phase) together with the drawing of the centralizing cabinet, highlighted in red in the attached Figure 2, wherein Figure 2 represents an architecture known in the prior art.

A three-phase transformer can be formed from three identical single-phase transformers, forming a transformer bank for high voltage applications, which generally correspond to values, but without limiting the invention, above 100kV, more preferably above 230kV, or also in special applications. Each single-phase transformer corresponds to one of the three phases, for example, phases A, B and C or phases 1, 2 and 3, depending on the agreed nomenclature, and there may also be a backup phase, for example, an R phase, depending on the agreed nomenclature.

Single-phase transformer and reactor banks are commonly installed in energy generation and transmission substations, since it is easier to carry out the replacement of a single-phase machine than a three-phase machine in the event of defects or malfunctions.

After assembling and testing each transformer that makes up a bank, including the backup phase, plus the centralizing cabinet, these are transported to the site and the field allocation activity begins, commissioning of each phase of the bank, including the backup, laying of control cables, point-to-point testing of these cables, commissioning with the PACS with the completion of the activity of replacing the phases with the backup phase.

In current solutions known in the prior art, as represented in the attached Figure 2, the centralizing cabinet receives all the wiring of phases A, B and C that make up a bank and, eventually, the wiring of a backup phase or phase R, with all the wiring leaving the cabinet for the control room. Each phase is connected to a column of sockets by a set of three sockets per phase, wherein each socket consists of a multipolar socket, which can be, for example, a female plug (fixed) and male plugs (mobile).

When one of the phases must be replaced, the respective male plugs are manually disconnected from their original position and connected to the plugs of the backup phase, thus replacing the signals originating from the replaced phase and using the signals from the backup phase.

In these cases, it is clear that removing the connection from the main phase bus and connecting it to the backup phase bus is an intervention that occurs manually, and this is especially true for the primary and secondary phases of the bank. Regarding the tertiary system, intervention is generally carried out through buses inside the medium voltage cubicles, but always manually. In both cases, the operator is exposed to inclement weather and the risk of electric shock when manually intervening in live cable plugs.

The challenge, therefore, lies in providing a digital substation comprising MUs installed as close as possible to the substation's primary equipment, for example, in the phase control cabinets of the respective equipment, eliminating the centralizing cabinets and enabling the replacement of one or more phases by one or more backup phases in a digital and automated manner, without the need for manual human intervention, wherein the MUs are responsible for acquiring the analog signals from the current transformers and temperature transducers, as well as the alarm, shutdown, supervision and command signals, making them available in communication protocols such as, but without limiting the invention, SV and GOOSE protocols.

### Prior art

An example of solutions that aim to virtualize procedures in transformer banks is the document entitled *"Sistema de Chaveamento Automático para Rápida Energização de Fase Reserva em Bancos de Transformadores Monofásicos"* (Automatic Switching System for Rapid Energization of the backup phase in Single-Phase Transformer Banks), published on the website https://www.treetech.com.br/sistema-de-chaveamento-automatico-para-rapida-energizacao-de-fase-reserva-em-bancos-de-transformadores-monofasicos/. This document discloses, on page 4, that a "[...] *central control unit carries out all the interlocking logic as well as the switching sequences, both to replace a phase in fault condition with a backup phase and to return to the original phase, always obeying the established preconditions, for example, the bank must be isolated on the 230, 138 and 13.8kV sides. These sequences can be carried out in automatic mode, where the entire replacement operation is carried out without the need for operator intervention, and in manual mode, where each opening or closing of disconnectors is supervised step-by-step by the operator [...].*

Although this solution aims to automate the switching of the disconnectors themselves, it still requires the existence of a centralizing cabinet and the need for manual intervention by the operator, as described on page 4 of the aforementioned prior art document, where it reads *"Before starting the transfer process, the operator must transfer the sockets from the faulted phase to the backup phase. This process is manual and is part of the transfer preconditions."*

As can be inferred from the foregoing descriptions, there is room for a centralizing cabinet virtualization system in single-phase transformer banks and single-phase reactors of digital substations and for a faulted phase monitoring and switching method of single-phase transformers and/or single-phase reactors of the digital substation without manual human intervention.

### Objects of the Invention

One of the objectives of the present invention is, therefore, a centralizing cabinet virtualization system in single-phase transformer and single-phase reactor banks of digital substations, in accordance with the characteristics of claim 1 of the attached set of claims.

Another objective of the present invention is a method for training a neural network for monitoring and switching faulted phases, according to the characteristics of claim 8 of the attached set of claims.

Yet another objective of the present invention is a faulted phase monitoring and switching method, according to the characteristics of claim 12 of the attached set of claims.

Still another objective of the present invention is to provide computer-readable memories containing a set of instructions that, when executed, perform the faulted phase monitoring and switching method in a digital substation, in accordance with the characteristics of claim 14 of the attached set of claims.

Additional features and details thereof are presented in the dependent claims.

### Brief description of the drawings

For better understanding and visualization of the object of the present invention, it will now be described with reference to the accompanying drawings, representing the technical effect obtained by exemplary embodiments without limiting the scope of the present invention, wherein, schematically:
Figure 1: shows a schematic view of a bus of a prior art substation;
Figure 2: shows a schematic view of a conventional connection diagram of transformer banks with centralizing cabinets of a prior art substation;

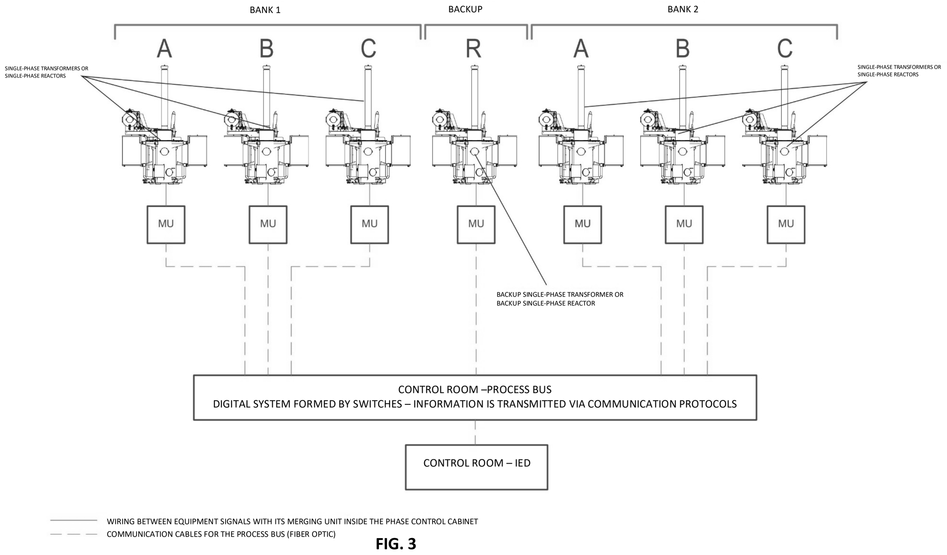

Figure 3: shows a schematic view of a connection diagram of virtualized transformer banks in accordance with the invention; and

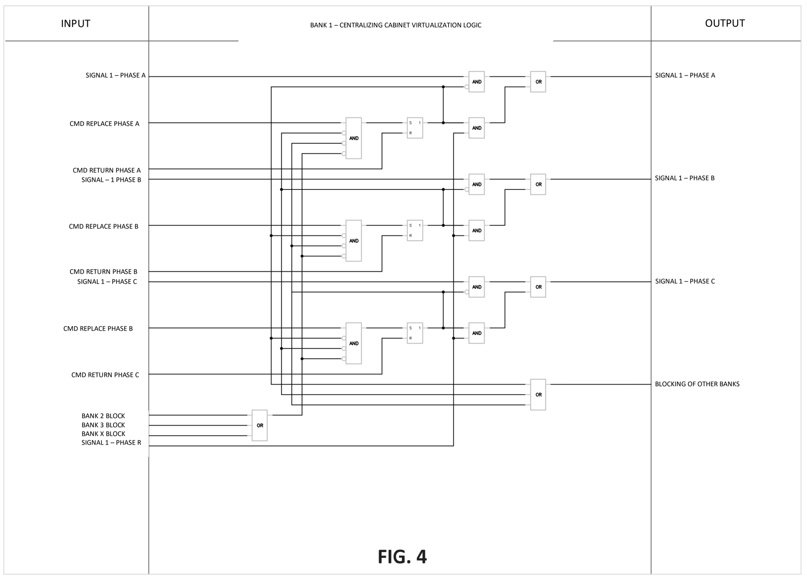

Figure 4: shows a logical diagram of the faulted phase monitoring and switching method by signals in accordance with the invention.

### Detailed description of the invention

The following detailed description refers to the appended drawings wherein, by way of non-limiting illustration, embodiments of the present invention are shown. These embodiments are described to enable a person skilled in the art to reproduce the results. Other embodiments resulting from structural, mechanical, logical, and electrical changes are possible and can be performed without departing from the spirit and scope of the present invention. The following detailed description should therefore not be understood in a restrictive or limiting manner.

The present invention relates to a centralizing cabinet virtualization system in single-phase transformer banks and single-phase reactors of digital substations, wherein the virtualization implies the elimination of the physical centralizing cabinet, with the MUs being installed inside the phase control cabinets of the respective equipment.

The present invention also relates to a faulted phase monitoring and switching method of single-phase transformers and/or single-phase reactors of the digital substation, in the event of abnormal operation of at least one of the phases (A, B, C) and backup phase (R) of at least one single-phase transformer and/or single-phase reactor bank, without manual human intervention.

Furthermore, the present invention relates to a method for training a neural network for monitoring the operating conditions of at least one of the phases (A, B, C) and the backup phase (R) and automatically replacing the faulted phases of at least one transformer bank and/or reactor bank and also to computer-readable memories containing a set of instructions that, when executed, perform the faulted phase monitoring and switching method in a digital substation.

In the context of the present invention, the term "substation" relates to any and all electrical energy substations for transforming electrical current and/or electrical potential, whether or not forming part of an electrical energy distribution system, in accordance with definitions known in the prior art. The term "digital substation" (DS) relates to a virtual substation in accordance with the invention, wherein the digitalization of the data exchanged between one or more components of the DS takes place as close as possible to the source of the data.

In the context of the present invention, the term "current transformer" (CT) relates to any and all electromagnetic devices known in the prior art that transform a high-value electric current into a low-value current and vice versa, maintaining the same phase relationship between the primary and secondary currents, performing tasks known in the prior art such as, for example, but without limiting the invention, current measurement, circuit protection, insulation between high-voltage circuit and low-voltage circuit, etc.

In the context of the present invention, the term "potential transformer" (PT) relates to any and all electromagnetic devices known in the prior art that transform a high-value electrical voltage into a low-value voltage and vice versa, maintaining the same phase relationship between the primary and secondary voltages, performing tasks known in the prior art such as, for example, but without limiting the invention, current measurement, circuit protection, insulation between high-voltage circuit and low-voltage circuit, etc.

In the context of the present invention, the term "reactor" relates to any and all devices used to control electrical current, voltage and other variables in energy distribution systems. They can be used to improve energy transmission efficiency, reduce energy losses, protect sensitive equipment, and maintain electrical system stability. Reactors can be classified in different ways, such as bus reactors, line reactors and compensator reactors, each with its specific function within the electrical system.

In the context of the present invention, the term "power transformer" relates to any and all interface devices between two different circuits, generally one high voltage and the other low voltage. Power transformers can be classified in different ways, such as step-up transformers, step-down transformers, phase-shifting transformers, each with its specific function within the electrical system.

In the context of the present invention, the term "IED" (abbreviation of the term Intelligent Electronic Devices) relates to any and all devices known in the prior art comprising a microprocessor-based integrated controller for energy system equipment, such as, for example, but without limiting the invention, circuit breakers, transformers, capacitor banks, as well as protection and control relays and the like.

In the context of the present invention, the term "CPR" (abbreviation of the term Centralized Protection Relay) relates to any and all protection systems composed of one or more protection devices applied, in a dedicated manner, to each line, bus, transformer, reactor, etc. of the electrical substation. This relay continuously monitors electrical energy and acts as an automatic safety device, detecting faults and opening circuit breakers to isolate faulted equipment and prevent damage to the entire system, where a centralized protection system consolidates the logic of individual relays. In short, a CPR results from the combination of various IEDs in a single hardware, allowing it to supervise various transmission lines, various transformers, various reactors, various buses, various feeders, depending on the size of the DS.

In the context of the present invention, the term "VPR" (abbreviation of the term Virtualized Protection Relay) relates to a protection system wherein dedicated physical relays are replaced by software that runs on a virtualized platform, consolidating the CPR logic in a virtual environment.

In the context of the present invention, the term "SKID" relates to any and all frameworks known in the prior art in the form of a chassis on which an energy substation is arranged.

In the context of the present invention, the term "MU" (abbreviation of the term Merging Units) relates to any and all data acquisition units for digitizing analog signals from CTs and PTs and binary signals from the yard equipment of a substation, also known in the prior art, consisting basically of an electrical circuit that receives analog voltage and current values, an analog-to-digital converter that samples the signals and a processor that standardizes the digital signal to work in accordance with standards such as, for example, but without limiting the invention, the IEC 61850 standard. Internal processing uses distinct blocks, which causes a delay in the signal. To correct this delay, an external time synchronizer (GNSS or similar) must be used.

In the context of the present invention, the term "GOOSE" (abbreviation of the term Generic Object Oriented Substation Event) relates to generic substation events (which is a control model defined in accordance with standards such as, for example, but without limiting the invention, the IEC 61850-8-1 standard), being a protocol that works with a fast and reliable engine for transferring event data in entire electrical substation networks, comprising, but without limiting the invention, binary supervision messages, alarms and commands, made available in message format to travel on Ethernet networks.

In the context of the present invention, the term "SV" (abbreviation of the term Sampled Values) relates to the messaging protocols responsible for transmitting instantaneous values of the primary voltage and current quantities of the power system of the energy substation, comprising, but not limiting the invention, sampled analog values made available in message format to travel on Ethernet networks, as defined, for example, but not limiting the invention, in the IEC-61850-9, IEC-61950-9-2LE and IEC-61869-9 standards.

In the context of the present invention, the term "MMS" (abbreviation of the term Manufacturing Message Specification) relates to an international standard protocol, defined in a standard, for example, but without limiting the invention in the IEC61850 standard, which deals with messaging systems for transferring real-time process data and supervisory control information between networked devices or computer applications, comprising, but without limiting the invention, client/server communication between IED and SCADA.

In the context of the present invention, the term "OPEX" (abbreviation of the term Operational Expenditure) relates to the operational expenses necessary for the operation of a DS.

In the context of the present invention, the term "CAPEX" (abbreviation of the term Capital Expenditure) relates to expenses related to long-term investments, generally in physical or intangible assets that impact the framework of the DS and serve to generate future returns.

In the context of the present invention, the term "SCADA" (abbreviation of the term Supervisory Control), also referred to as SCADA supervisory system, relates to systems that use software to monitor and supervise the variables and devices of industrial and non-industrial processes and equipment connected through specific communication servers/drivers.

In the context of the present invention, the term "Ethernet Network" relates to any and all wired computer networking technologies commonly used in local area networks, metropolitan area networks, and wide area networks.

In the context of the present invention, the term " PTP " (abbreviation of the term Precision Time Protocol) relates to any and all protocols used to synchronize the system time in various systems on a LAN to a common master clock on the LAN, especially important in latency-sensitive environments, as in the case of a digital substation of the invention, being a high-precision time synchronization signal made available via an Ethernet network, defined in standards such as, for example, but without limiting the invention, the IEEE1588v2 standard.

In the context of the present invention, the term "GNSS" (abbreviation of the term Global Navigation Satellite System) relates to any and all equipment known in the prior art that uses a constellation of satellites in Earth orbit to provide positioning, timing and navigation information to users anywhere on the planet. In energy substations, GNSS is used for several purposes, primarily for time synchronization and precise positioning, crucial information for the coordinated and efficient operation of power grids, ensuring that devices and equipment are operating in the same time interval, which is essential for the reliable transmission and distribution of power.

In the context of the present invention, the term "phase selector switches" relates to, in a broader sense, any and all devices combined to execute sectioning and/or switching, generally without the presence of electric current, and therefore capable of connecting and disconnecting electrical circuits and also switching between electrical circuits, such as, for example, but without limiting the invention, disconnecting and isolating the circuit of a faulted phase and connecting to the circuit of a backup phase.

In the context of the present invention, the term "SNMP" (abbreviation of the term Simple Network Management Protocol) relates to, in a broader sense, any and all standard internet protocols for managing devices in IP networks, including, but not limited to, routers, computers, servers, workstations, printers, racks, etc. and, in a more restricted sense, to any and all protocols used to report what is happening in network assets, in this case GNSS and switches.

In the context of the present invention, the term "SCL" (abbreviation of the term Substation Configuration description Language) relates to the language and representation format specified in standards such as, for example, but without limiting the invention, in the IEC 61850 standard for configuring electrical devices in substations. Substation Configuration Language (SCL) is a standardized language used to describe and configure the components and systems within an electrical energy substation, allowing different protection, control and monitoring devices to be configured and interoperable, facilitating integration and communication between them. The SCL specifies a hierarchy among configuration files by defining four groups: System Specification Description (SSD) File, IED Capabilities Description (ICD) File, Substation Configuration Description (SCD) File, Configured IED Description (CID) File, Configured IED Description (CID) File and Instantiated IED Description (IID) File and System Exchange Description (SED) File, with files of the ICD, CID, SSD, SCD, IDD and SED types, among others, being related to the SCL and generally being part of standards, such as, for example, but without limiting the invention, the IEC 61850 standard, with the SCL file and its derivatives being essential to ensure the interoperability and proper functioning of the devices within an electrical energy substation, facilitating the configuration, maintenance and operation of the electrical system. SCL files can be created in several formats, such as UML (Unified Modeling Language), XML (Extensible Markup Language), IEC 61850 (a communication standard for substation automation), among other proprietary software formats used in the electrical engineering field.

In the context of the present invention, the term "SCD" (abbreviation of the term Substation Configuration Description) relates to files that can be created in several formats, such as XML (from the acronym Extensible Markup Language), IEC 61850 (a communication standard for substation automation), among other proprietary software formats used in the area of electrical engineering, comprising the description of the complete details of the substation, containing, for example, information on all IEDs in the substation, communications configuration data and a complete description of the substation, comprising information on:
- The substation topology containing details about the physical framework of the substation, such as the arrangement of equipment, layout of circuit breakers, transformers, relays, disconnect switches, phase selector switches, buses and other devices;
- Equipment configuration, such as specific information about each component, including its technical characteristics, nominal capacities, manufacturing data and electrical connections;
- Diagrams and schemes such as drawings and diagrams that illustrate the arrangement of equipment and the interconnection between them, which may include single-line, three-line, logical diagrams and other schemes that represent the electrical configuration of the substation; and
- Control and protection information, such as details about the control, protection, automation and monitoring systems used in the substation, including operating logic, configuration of protection relays, SCADA systems and other control devices.

In the context of the present invention, the term "CID" (abbreviation of the term Configured IED Description) relates to a protocol used for communication between an IED configuration tool and an IED, containing specific information about how each individual IED is configured within the substation, including operating parameters, communication settings, protection settings, among others.

In the context of the present invention, the term "IID" (abbreviation of the term Instantiated IED Description) relates to a file that defines the configuration of an IED for a design and is used as a data exchange format from the IED configurator to the system configurator.

In the context of the present invention, the term "SED" (abbreviation of the term System Exchange Description) relates to a file that must be exchanged between system configurators of different designs.

In the context of the present invention, the expression "operating condition" should be understood, broadly, as being the actual operating state in real time of one or more components of the DS and/or of the communication between two or more components of the DS and/or of the communication between at least one of the components of the DS and the SCADA and, restrictedly, to the operating condition of the transformer and/or reactor banks, especially, but without limiting the invention, of the phases (A, B, C) and of at least one backup phase (R), when present, and may include, but without limiting the invention, one or more normal operating conditions and/or one or more abnormal operating conditions of the phases (A, B, C, R). This comparison, made by the processing unit, results in data and/or output instructions in the form of warnings and/or deviation and/or inconsistency alarms and/or also in the form of suggestions and/or procedural instructions for maintaining the operation of the phases (A, B, C, R) and/or correcting the parameters of one or more components of the DS or the DS as a whole and, in the case of using a neural network for monitoring and switching faulted phases, the data and/or output instructions will be generated in the form of warnings and/or alarms and also of suggestions and/or procedural instructions for maintaining the operation of the phases (A, B, C, R) and/or correcting the parameters of one or more components of the DS or the DS as a whole.

In the context of the present invention, a normal operating condition, or simply normal condition, indicates that the transformer and/or reactor banks are operating normally with their respective phases (A, B, C) and that the backup phase (R) is not connected to the power system. It should be noted that a normal operating condition is, preferably, but without limiting the invention, a condition wherein there is no exchange of fault and/or defect messages between at least one MU of the respective bank and at least one IED and/or CPR and/or VPR.

In the context of the present invention, an abnormal operating condition, or simply abnormal condition, indicates that at least one of the phases (A, B, C) of the transformer and/or reactor bank is damaged and/or inoperative and/or operating with a defect and/or has suffered an accident and that it will not be able to return to operation in a short time, requiring its replacement by at least one backup phase (R).

At the level of low voltage signals, these are switched through blocks and releases in programmed logic within the IEDs and/or CPRs and/or VPRs, by means of message protocols such as, for example, but without limiting the invention, GOOSE and/or SV messages, which are described, for example, but without limiting the invention, in DS SCL type files.

It should be noted that the operating conditions of the invention take into account the result of the comparison between the expected and ideal parameters for each of the phases (A, B, C) and backup (R) of at least one of the component banks of the DS and evaluated by the processing unit and/or IEDs and/or CPRs and/or VPRs (or by a neural network of the processing unit trained in accordance with the machine learning model of the invention), in particular, but without limiting the invention, of one or more phases (A, B, C) of the transformer and/or reactor banks, and may include, in addition to monitoring the integrity, completeness and synchronization of the messages exchanged, additional parameters relating to the values contained in the messages, that is, the physical quantities read from the IEDs and/or CPRs and/or VPRs *versus* the expected values.

As already above-described, it is possible, from the association of the parameters of the messages received with the expected values and ranges, in addition to the identification of a normal operating condition, to obtain information indicative of one or more abnormal operating conditions of one or more phases (A, B, C) of one or more transformer and/or reactor banks. This information allows monitoring of the phases (A, B, C) and helps to accurately determine the need to replace at least one of the faulted phases (A, B, C) with at least one backup (R). It should be noted that, even after replacing one of the faulted phases (A, B, C) with at least one backup phase (R), the system of the invention will continue to monitor the operating conditions of the phases (A, B, C) and the backup phase (R), in particular, blocking the use of the backup phase (R) in operation by one or more other transformer and/or reactor banks of the DS. It should also be noted that, in a normal operating condition of the phases (A, B, C), the normal operating condition of the backup phase (R) will be the condition of switched off or inactive. Furthermore, as already above mentioned, a normal operating condition is, preferably, but without limiting the invention, a condition wherein there is no exchange of fault and/or defect messages between at least one MU of the respective bank and at least one IED and/or CPR and/or VPR.

In the context of the present invention, the term "monitor" relates to one or more tasks of monitoring an operating condition of one or more phases (A, B, C) and the backup phase (R), also comprising terms related to monitoring and their synonyms and/or equivalent terms such as, for example, but without limiting the invention, supervision, monitoring, surveillance, verification, evaluation, measurement, etc.

Also in the context of the present invention, the term "neural network" relates to a machine learning model that may be a convolutional neural network, wherein the term "train" relates to adjusting the parameters of the machine learning model so that, from a number of reference parameters associated with the ideal and/or expected values for the phases (A, B, C) and backup phase (R), it is capable of, from one or more input data (input) of the IEDs and/or CPRs and/or VPRs, providing at least one output data or instruction and, in the event of an abnormal operating condition, commanding the replacement of a faulted phase (A, B, C) with a backup phase (R). It should be noted that, in addition to a convolutional neural network, it is also possible to use other learning algorithms such as, for example, Q-learning or even LLM (abbreviation of the term Large Language Model) and other appropriate networks and/or algorithms.

A central server is, in the context of the invention, a computer or computer system or computer circuit or even a set of instructions executable on a pre-existing computer of the DS, with one or more centralized computing systems or one or more data processing centers, which makes services and resources available or stores them in and through a communication and data network. It comprises one or more electronic processors capable of executing tasks from a computer program or set of instructions stored on a computer-readable medium, preferably a computer equipped with a processor, memory for data storage, connection to one or more communication and data networks and to one or more remote databases and/or an information storage and retrieval environment, local and/or centralized and/or decentralized and/or in the cloud, and also equipped with all the usual peripherals of the prior art, being capable of exchanging information with the electronic and physical medium, interfaces, applications, mobile equipment, other memory devices, etc.

A server may be at least a web server that delivers or serves web pages, an application server that handles application operations between users and applications or databases, a cloud server, a database server, a file server, a service server, a game server implementing games or services for a game, and a media server providing media such as streaming video or audio.

The invention server may also be a remote control center for the DS user/operator/client/maintainer.

A computer program in accordance with the invention is a program executable on a processor of the invention and thus also executable on a processor of the portable equipment of the invention, for example in application form.

A database or database in accordance with the invention is any and all sets of data, files, information, instructions and records that form organized collections of data that are related to each other, hosted in one or more memories or storage devices of the system of the invention and that can be accessed, fed and managed by the data processing centers of the invention.

Both the servers and the processors and other equipment and devices of the system of invention may comprise one or more databases, independent and/or interconnected.

A communication and data network, in the context of the present invention, comprises a centralized or decentralized network that interconnects one or more active or passive components of the system in accordance with the invention. The servers, processors, data processing center, database and portable equipment of the invention may be connected to one or more communication and data networks, ethernet networks, physical memories, cloud and similar, the internet, one or more data and/or program clouds, computer terminals, mobile devices, telephone devices, barcode readers, QR-Codes, Data Matrix codes and the like, credit cards, NFC or BLE devices, gas stations and service stations, in short, to any equipment or interface necessary, directly or indirectly, for the execution of a method in accordance with the invention.

The communication and data network may comprise any wired or wireless connection, the Internet, or any other form of communication, and may comprise any number of different communication and data networks between any server, devices, resource and system and/or other servers, devices, resources, and systems described herein. The communication and data network may enable communication between various computing resources or devices, servers and systems, and may employ different types of networks, for example, but not limited to computer networks, telecommunications networks (e.g. cell phones), mobile, cable, radio and the like wireless data networks and any combination of the foregoing and/or other networks.

A processor is, therefore, a processing unit and/or IED and/or CPR and/or VPR that performs the instructions of a computer program or application, processing and executing arithmetic, logical operations and data input and output, the computer program being stored in a computer-readable medium with memory for data storage, connection to one or more communication and data networks and to one or more remote databases and/or an information storage and retrieval environment, local and/or centralized and/or decentralized and/or in the cloud, and also equipped with all the usual peripherals of the prior art, being capable of exchanging information with the electronic and physical medium, interfaces, applications, mobile equipment, other memory devices, etc.

Processing units in accordance with the invention can be, form part of, or, be subdivided into one or more modules. The term module, in accordance with the invention, relates to an application-specific integrated circuit (ASIC), an electronic circuit, a processor (shared, dedicated or group of processors) and a memory which executes one or more programs software or firmware. It further relates to a combinational logic circuit and/or other suitable components capable of providing the functionalities herein.

A processing circuit in accordance with the invention may also be configured to determine a neural network in accordance with the invention.

This processing circuit may therefore include a processor such as a central processing unit (CPU), a microcontroller, a microprocessor, a field programmable gate array (FPGA), a graphics card, or special hardware for convolutional neural networks such as the trained convolutional neural network of the invention.

A computer-readable memory or computer-readable medium, in the context of the present invention, is any memory or storage device, remote or local, volatile or non-volatile, transient or non-transitory (permanent).

### System in accordance with the invention

A centralizing cabinet virtualization system in single-phase transformer and/or single-phase reactor banks of digital substations, according to the present invention, presupposes the existence of at least one energy substation (DS) comprising at least one single-phase transformer bank and/or at least one single-phase reactor bank, at least one SCADA, at least one ethernet network, at least one GNSS, one or more switches, one or more interrupters, one or more IEDs and/or CPRs and/or VPRs, one or more drivers, transformers in general, capacitor banks, storage batteries, compensators, generators, eventually one or more electric motors and/or fans and/or heat exchangers, smoke detectors, fire alarms, audible and/or light alarms and all other components necessary for the operation of a substation.

The system of the invention comprises at least one processor or processing unit, independent or not of the DS SCADA, this processing unit comprising at least one memory that stores information and computer-executable instructions and at least one trained convolutional neural network, wherein the processing unit and/or IED and/or CPR and/or VPR is configured to provide output data and/or output instructions about one or more operating conditions of one or more single-phase transformer banks and/or single-phase reactor banks, in response to the reception, as input information, of one or more messages and/or input information of each of the phases (A, B, C) and the backup phase (R), obtained from at least one MU of the bank and transmitted to one or more IEDs and/or CPRs and/or VPRs, wherein the execution of the instructions executes one or more steps of the method of monitoring and switching the phases (A, B, C, R) of the single-phase transformer banks and/or reactors single-phase digital substation.

A system of the invention comprises at least one MU for each single-phase transformer bank and/or for each single-phase reactor bank, at least one protection IED and/or CPR and/or VPR for each single-phase transformer bank and/or for each single-phase reactor bank, at least one control IED and/or CPR and/or VPR for each single-phase transformer bank and/or for each single-phase reactor bank, at least one phase selector switch for each phase (A, B, C) and backup phase (R) of a single-phase transformer bank and/or for each single-phase reactor bank for selecting the bus to which each phase (A, B, C) and backup phase (R) will be connected.

It should be noted that the virtualization of the centralizing cabinet of a single-phase bank, in accordance with the invention, can be carried out from just one MU installed in the control cabinet of each phase (A, B, C), however, as the MU will digitalize any and all types of signals existing in the equipment, such as, for example, but without limiting the invention, current signals, intrinsic protections, forced ventilation, tap switch, supervisions and any other type of signal, it is important that there is redundancy, that is, at least two MUs per phase control cabinet. These MUs must be connected to a communication bus, which may be the station bus, but preferably, but without limiting the invention, the process bus, making the digitized information available in multicast communication protocols such as GOOSE and SV, but not limited to these protocols or this type of protocol. In this way, IEDs and/or CPRs and/or VPRs will be able to use the signals in their logic and virtualize the centralizing cabinet.

In this way, in the event of detecting an abnormal operating condition, through a command from the SCADA and/or processing unit, for example, the IED and/or CPR and/or VPR will check whether the equipment bank is de-energized, will perform the commands to open and close the phase selector switches to isolate and replace the faulted phase (A, B, C) and the IEDs and/or CPRs and/or VPR will block the messages received from the MUs of the faulted phase (A, B, C), replacing them with those of the backup phase (R).

In the context of the present invention, a phase selector switch is, preferably, but without limiting the invention, an electrical device used to section and isolate parts of an electrical circuit and switch between circuits, wherein these phase selector switches must be able to react to an instruction from the processing unit and/or SCADA and/or IEDs and/or CPRs and/or VPRs, whose main function is to guarantee safety during maintenance, repair operations or in the event of faults in the electrical circuit, and may be, for example, but without limiting the invention, motorized phase selector switches for remote control.

In addition to at least one memory, at least one processing unit and at least one trained neural network, the system of the invention may also comprise:
- At least one human-machine interface (HMI) and/or processing equipment for acquiring and presenting information/instructions;
- At least one database;
- At least one communication and data network;
- One or more sets of equipment input information;
- One or more sets of data and/or output instructions from IEDs and/or CPRs and/or VPRs; and
- Other devices and/or equipment necessary for the operation of the system and the execution of the method in accordance with the invention.

The MUs, IEDs, CPRs, VPRs, memory, processors, processing equipment for acquiring and presenting information/instructions, servers, databases, communication and data networks and other devices and/or equipment eventually and additionally comprised by the system, are all interconnected by the DS communication buses and/or by one or more communication and data networks. Pictures and data are stored as one or more electrical signals and the processing of these signals is done by one or more components of the system of the invention.

With the installation of MUs in the control cabinets of each phase (A, B, C) that make up a single-phase equipment bank, including the backup phase (R), all signals are digitized (current, alarms, shutdowns, supervisions, commands, etc.) and made available on the bus or process network through multicast protocols such as, for example, but without limiting the invention, GOOSE and SVs messages (according to IEC-61850 standard).

All MUs of phases (A, B, C), including the backup phase (R), will publish GOOSE and SVs messages with the digitized information and the protection and/or control IEDs and/or CPRs and/or VPRs will subscribe to the messages of the respective bank and of the backup phase (R).

The IED and/or CPR and/or VPR, under normal conditions, will use the GOOSE and SV messages provided by the phases (A, B, C) of the bank and, in the case of a replacement, the IED and/or CPR and/or VPR will block the message from the replaced phase (A, B, C) and will consider the message from the backup phase (R). The phase replacement command (A, B, C) may occur on the IED HMI and/or CPR and/or VPR and/or via the substation SCADA and/or via the processing unit.

In terms of design, the virtualization that is the object of the present invention provides a time gain in terms of schedule, as it will no longer be necessary to create the functional and construction designs of the centralizing cabinet. Only the single-phase equipment cabinet will be designed, which will be typical for the other equipment.

Without a centralizing cabinet, there are gains in the field for assembling the banks, as it will not be necessary to lay and commission command and command cables, only the AC and DC supply cables, which improves the DS CAPEX.

Regarding operation, the DS maintainer will no longer need to operate on a panel in the yard or external area of the DS, reducing the risk of accidents. In addition to safety, replacing a phase will occur more quickly, since programmed and tested logic will be activated, which reduces the customer's OPEX.

The GOOSE and SV information, in the MUs of each phase including the backup, are configured in SCL type files, to then be uploaded into the IEDs and/or CPRs and/or VPRs.

These files are uploaded into the invention's computer-readable memory, which then has all the information about how the communication network between the system elements is formed, for example, how the MUs and IEDs and/or CPRs and/or VPRs communicate with each other and what information is being made available on the network (GOOSE and SVs messages).

With the application of at least one MU in the cabinets of each equipment, whether three-phase or single-phase with or without backup, the system of the invention applies to three possible scenarios.

In the case of three-phase equipment, all signals are transmitted from the equipment directly to the MU(s) via the wired or wireless communication and data network and/or Ethernet network and no longer to the terminals, since virtualization, the object of the present invention, eliminates the centralizing cabinet. From the phase control cabinet, the signals proceed to the IEDs and/or CPRs and/or VPRs in the control room via the process bus and/or wired or wireless communication and data network and/or Ethernet network. It should be noted that, since the signals are digitized, fiber optic cables, wireless networks, etc. can be used.

In the case of single-phase equipment without a backup phase (R), all signals are transmitted from the equipment directly to the MU(s) via the wired or wireless communication and data network and/or Ethernet network and no longer to the terminals, since virtualization, the object of the present invention, eliminates the centralizing cabinet. From the cabinet, the signals proceed to the IEDs and/or CPRs and/or VPRs in the control room via the process bus and/or wired or wireless communication and data network and/or Ethernet network. It should be noted that, since the signals are digitized, fiber optic cables, wireless networks, etc. can be used;

In the case of single-phase equipment with a backup phase (R), all signals are transmitted from the equipment directly to the MU(s) via the wired or wireless communication and data network and/or Ethernet network and no longer to the terminals, since virtualization, the object of the present invention, eliminates the centralizing cabinet. From the cabinet, the signals proceed to the IEDs and/or CPRs and/or VPRs in the control room via the process bus and/or wired or wireless communication and data network and/or Ethernet network. It should be noted that, since the signals are digitized, fiber optic cables, wireless networks, etc. can be used. In this case, the backup phase will also have at least one MU.

Once the signals are digitized in the phase control cabinets of the respective phases (A, B, C) and backup phase (R), it is necessary to create engines so that the IEDs and/or CPRs and/or VPRs acquire the signals of the phases that make up a bank even when the backup phase (R) replaces one of the phases (A, B, C) that presented a defect, which is achieved with the virtualization of the centralizing cabinet of the respective bank, remembering that the virtualization of the centralizing cabinet corresponds to the elimination of the centralizing cabinet, improving the prior art in an unprecedented and inventive way.

### Method for training a neural network

The method of the invention for training a convolutional neural network for monitoring and switching faulted phases, wherein a neural network relates to a machine learning model, is a computer-implemented method capable of adjusting the parameters of the machine learning model so that, from a number of reference parameters associated with the ideal and/or expected values for the phases (A, B, C) and backup phase (R), it is capable of, from one or more input data (input) from the IEDs and/or CPRs and/or VPRs and/or the processing unit, providing at least one output data or instruction and, in the event of an abnormal operating condition, commanding the replacement of a faulted phase (A, B, C) with a backup phase (R).

A trained convolutional neural network in accordance with the invention may comprise interconnected groups of artificial neurons (e.g., neuron models), and may also be a computational device or be represented as a method that will be executed by a computational device.

A trained convolutional neural network in accordance with the invention may be, for example, but without limiting the invention, a deep feedforward trained convolutional neural network, with an architecture such that it delivers results quickly and accurately and that it can also and especially be executed on portable processors such as, for example, in a manner not limiting the present invention, processors of cell phones, smartphones, tablets and the like, with high processing speed and concomitant accuracy, and may also comprise layers of neurons that can be configured in a receptive field arranged side by side.

The preferred neural network, without limiting the scope of the invention, is a convolutional neural network, but may be any other similar suitable architecture as long as this model is trained for this purpose, such as the convolutional neural network mentioned above. Furthermore, the trained neural network of the invention may comprise the combination of two or more architectures.

The training serves to configure the neural network to provide diagnostics and instructions unambiguously associated with each phase (A, B, C) and backup phase (R) of at least one transformer and/or reactor bank of the DS, in response to the reception, as input, of the measured values of each component and/or of the messages and/or input information received from the IEDs and/or CPRs and/or VPRs and/or processing unit.

Once the convolutional neural network has been trained and the system of the invention, as a whole, has been fed with the information and instructions described herein, the processing units and/or IEDs and/or CPRs and/or VPRs will be ready to monitor the phases (A, B, C) and the backup phase (R) and, in the event of abnormal operation, command the replacement of at least one faulted phase (A, B, C), for example, the first phase (A), by at least one backup phase (R).

For training the convolutional neural network of the invention, at least one database in the form of at least one file is used.

The database for training is a historical database collected by the owner of the present invention online, between the years 2021 and 2024, from 73 transformer equipment through its own monitoring system and, offline, between the years 2020 and 2024, from 1,302 transformer equipment through its own reports. Historical data of abnormal operation may include, for example, but without limiting the invention, data such as pressure and/or quantity of gas in the transformer, absence of electrical current or voltage, current or voltage above or below the expected ideal, etc.

The training database thus generated comprises electrical and thermal data monitored by IEDs and data centralization systems in transformers. Anomalies are detected after analyzing at least one year of training data and based on parametric and non-parametric statistical metrics. This data is reevaluated daily to refine the database and learning algorithm, thus enabling better accuracy in future diagnoses.

Therefore, the training database includes practical experiences resulting from various years of monitoring transformer banks, comprising historical series of abnormal operation information such as, for example, but without limiting the invention, information collected and recorded as being indicative and/or conclusive of an abnormal operation and/or fault and/or defect of at least one phase (A, B, C) and/or backup phase (R). The training database also comprises the ideal and/or expected reference data for the phases (A, B, C) of each of the transformer banks and/or at least one file or database comprising the expected physical quantities for the phases (A, B, C). It should also be noted that the database may also comprise, but without limiting the invention, data from an DS SCL file and/or other additional files or databases.

This information is unequivocally assigned to at least one phase (A, B, C) and/or backup phase (R), wherein the trained convolutional neural network is fed with this information that will assist in detecting at least one abnormal operating condition as input data and in the subsequent output instruction in the form of a warning and/or alarm and, mainly, for carrying out the replacement of at least one faulted phase (A, B, C) by at least one backup phase (R).

With this database, a deep feedforward convolutional neural network can be created, which may include layers of neurons that can be configured in a receptive field arranged side by side, wherein the input data are data read from the IEDs and/or CPRs and/or VPRs and/or processing unit and the output data comprise at least one command for at least one phase selector switch to disconnect the faulted phase (A, B, C) and connect the backup phase (R).

A method for training a neural network for monitoring and switching faulted phases, in accordance with the invention, comprises the following method steps:
(i) Providing at least one database in the form of at least one file with the ideal and/or expected historical and/or reference data for the phases (A, B, C) of each of the transformer banks and/or at least one file or database that includes the expected physical quantities for the phases (A, B, C);
(ii) Configuring a neural network to receive, as input, the input data set, wherein each training input data set corresponds to the respective historical and expected data sets, according to the at least one database in the form of at least one file with the historical data and with the ideal and/or expected reference data for the phases (A, B, C) and backup phase (R) of each of the transformer banks;
(iii) Receiving training input data;
(iv) Configuring the neural network to assign to each phase (A, B, C) and backup phase (R) at least one expected value, according to the at least one database in the form of at least one file with the ideal and/or expected reference data for the phases (A, B, C) and backup phase (R) of each of the transformer banks and/or at least one file or database that comprises the expected physical quantities for the phases (A, B, C) and backup phase (R);
(v) Configuring the trained convolutional neural network to, in response to input data representing a normal operating condition of phases (A, B, C) and backup phase (R), not generate any blocking signal for any of the circuit breakers associated with phases (A, B, C) and backup phase (R) and not generate any alarm;
(vi) Configuring the trained convolutional neural network to, in response to input data representing an abnormal operating condition of the phases (A, B, C), generating a blocking signal to the IED and/or CPR and/or VPR to block the circuit breaker associated with the faulted bank, generating an alarm and, in response, as output data, generate an automatic instruction and/or wait for the DS operator to command the replacement of the faulted phase (A, B, C) by the backup phase (R), wherein this command can be given through SCADA (via MMS message) or through the IED (buttons and/or keys and/or HMI) and/or CPR and/or VPR and/or processing unit;
(vii) Configuring the trained convolutional neural network to remove the internal blocking signal from the IEDs and/or CPRs and/or VPRs to unlock the operation of the circuit breakers;
(viii) Configuring the trained convolutional neural network to block the use of phase (R) by other banks parallel to the bank that is using the backup phase (R); and
(ix) Producing a neural network by repeatedly training the trained convolutional neural network with each of the training data sets for each of the phases (A, B, C) and backup phase (R).

It should be noted that the command to replace the faulted phase (A, B, C) with the backup phase (R) can also be performed by the DS operator, as a form of confirmation and/or human supervision of the trained convolutional neural network. In this case, the output data from the trained convolutional neural network could be, in addition to the alarm, at least a suggested procedure to be confirmed by the operator. This confirmation can be made by the operator from an HMI and/or SCADA control panel, etc.

### Faulted phase monitoring and switching method

A faulted phase monitoring and switching method, in accordance with the invention, is a computer-implemented method of monitoring the phases (A, B, C) and backup (R) of the single-phase transformers and/or single-phase reactors of the digital substation and the replacement by switching of at least one faulted phase (A, B, C) by at least one backup phase (R), without manual human intervention, the method being executed by one or more components of the system of the invention.

The protection and control IED and/or CPR and/or VPR of a bank of single-phase equipment receives, from at least one MU of at least one of the phases (A, B, C) that make up at least one transformer and/or reactor bank, the digitized information of the phases (A, B, C) of said bank (A, B, C) plus that of the backup phase (R), including the states of the phase selector switches, if applied, which will be made available through multicast protocols, such as, for example, but without limiting the invention, GOOSE and SV messages, from MU type unit(s). Internally, the IED and/or CPR and/or VPR is configured to execute a logic for selecting the messages it will use in its functions, and in normal operating conditions, even though it is receiving information from the four phases (A, B, C, R), the information from phases (A, B, C) will be used, and the signals from the backup phase (R) are blocked internally in the IED and/or CPR and/or VPR. It should be noted, once again, that a normal operating condition is, preferably, but without limiting the invention, a condition wherein there is no exchange of fault and/or defect messages between at least one MU of the respective bank and at least one IED and/or CPR and/or VPR.

The input data received from the MUs are submitted to the processing unit and thus to the trained neural network of the invention and, in case of normal operation, no alarm signal and/or suggestion and/or switching instruction will be generated.

In case of abnormal operation, when at least one MU of at least one transformer and/or reactor bank sends an abnormal operation signal of at least one of the phases (A, B, C), that is, when there is a need to replace one of the phases (A, B, C), such as, for example, the faulted phase (A) of at least a first bank, referred to as bank 1, the sequence of maneuvers, which correspond to the method steps of the method of the invention, comprises the following steps.

The neural network sends to the IED and/or CPR and/or VPR of bank 1 of the faulted phase (A), through the processing unit, a command to replace the faulted phase (A) of bank 1, for example, with the backup phase (R). It should be noted that the trained convolutional neural network can also send an alarm and a suggested procedure to the DS operator, where in the DS operator, either through SCADA (via MMS message) or through the IED (buttons and/or keys and/or HMI) and/or CPR and/or VPR, commands the replacement of the faulted phase (A) of bank 1, for example, by the backup phase (R).

The processing unit and/or IED and/or CPR and/or VPR checks whether the corresponding bank 1 is isolated, i.e. whether the circuit breakers are open and bank 1 without voltage is switched off. At this point, the circuit breakers are interlocked at the IED and/or CPR and/or VPR so that they are not operated until the phase (A) replacement is complete. Until the replacement is completed, an internal signal is generated to the IED and/or CPR and/or VPR to block the operation of the circuit breakers.

The processing unit and/or IED and/or CPR and/or VPR, sends commands via protocol, GOOSE, for example, to the MUs installed in the yard to execute the opening of the switches of each winding of the equipment that connects to the main bus of the DS and close the phase selector switches to connect the backup phase (R) to the main bus of the DS; If it is a transformer bank, this switching will occur in each winding (primary, secondary, tertiary, etc.) and the neutral(s). If it is a reactor bank, it will occur in the primary winding and in the neutral.

Once all phase selector switches have completed their maneuvers, the IED and/or CPR and/or VPR blocks the information on the faulted phase (A), originating from the MU(s) of this equipment, in its logic and starts using the information published by the MU(s) of the backup phase (R). It should be noted, once again, that, until the replacement is completed, an internal signal is generated to the IED and/or CPR and/or VPR to block the operation of the circuit breakers (interlocking).

The circuit breaker interlock will be deactivated by removing the blocking signal, releasing the command for the operator to energize bank 1 with the backup phase (R)

While the backup phase (R) is in use by any bank, as in the example bank 1, the other banks parallel to this one will be blocked from using the switched backup phase (R) to replace the faulted phase (A). This is because the IED and/or CPR and/or VPR will generate a blocking signal and distribute it to the other IEDs and/or CPRs and/or VPRs of the other banks.

At any time during the sequence of steps above-described, if the processing unit and/or IED and/or CPR and/or VPR has not received feedback, via MU(s), that the maneuver was successful, such as, for example, if the processing unit does not receive confirmation of the closing of a phase selector switch, the system will trigger an alarm and the circuit breakers will be blocked. It should be noted that, in the event that a switching operation has not been completed due to a mechanical failure of the phase selector switch, manual intervention will be necessary to unlock and/or complete the switching operation.

It should also be noted that, although the example above referred to the equipment's IEDs, this solution is also valid for the use of CPRs and/or VPRs.

Therefore, a faulted phase monitoring and switching method in accordance with the invention comprises the following method steps:
I. Obtaining, by means of at least one IED and/or CPR and/or VPR, from at least one MU of at least one of the phases (A, B, C) of a transformer bank, at least one input information of at least one of the phases (A, B, C);
II. Applying to the input information, in a processing unit, a machine learning model, preferably, but without limiting the invention, in the form of a neural network, preferably a trained convolutional neural network;
III. Obtaining, in the processing unit, as a result of applying the machine learning model, at least one output information equivalent to an operating condition of at least one of the phases (A, B, C); and
IV. Em case of normal operating condition, not generating any alarm signal and/or suggestion and/or switching instruction; or
V. Em the event of an abnormal operating condition, generating, by means of the processing unit and/or IED and/or CPR and/or VPR, an alarm signal and an instruction in the form of a command to replace the at least one faulted phase (A, B, C) with at least one backup phase (R) from the bank;
VI. Checking, using the processing unit and/or IED and/or CPR and/or VPR, whether the corresponding bank is isolated, whether the circuit breakers are open and the bank is without voltage;
VII. Interlocking the circuit breakers, through the processing unit and/or IED and/or CPR and/or VPR, generating an internal signal to the IED and/or CPR and/or VPR to block the operation of the circuit breakers;
VIII. Sending, through the processing unit and/or IED and/or CPR and/or VPR, commands via multicast protocol to at least one MU to open the switches of each winding of the equipment that connects to the main bus of the SE and close the phase selector switches to connect the backup phase (R) to the main bus of the SE;
IX. Blocking, through the processing unit and/or IED and/or CPR and/or VPR, the information of the faulted phase (A, B, C), originating from the at least one MU, in its logic and use the information published by the at least one MU of the backup phase (R);
X. Receiving, through the processing unit and/or IED and/or CPR and/or VPR, from the at least one MU, a switching maneuver completion signal; and
XI. Deactivating, through the processing unit and/or IED and/or CPR and/or VPR, the interlocking of the circuit breakers by removing the blocking signal, releasing a command to energize the corresponding bank with the at least one backup phase (R).

The operating logic of monitoring and switching faulted phases (A, B, C) by at least one backup phase (R), illustrated in Figure 5, represents a method of signal selecting method (which can be digital, GOOSE, for example, or analog, SV, for example) between the phases that make up a bank (A, B, C) and the backup phase (R). On the right side of the figure, the results of the logic, the outputs, are presented. The first three are the result of logic selection. Each of the three results comes from an "OR" gate that receives the signal from two "AND" gates. These "AND" gates, which bring the released signal to be used at the output, from the phase itself (A, B, C) or from the backup phase (R). The blocking and releasing of the phase (A, B, C) to be used or not is determined by the status of the "LATCH" ("SET-S/RESET-R"). When the IED and/or CPR and/or VPR receives the phase replacement command, a signal release logic is performed, the "AND" gate before the "LATCH". To release this signal, no other phase (A, B, C) of the bank can be using the backup phase (R), as well as receiving the signal that no other parallel bank is using the backup phase (R). In this way, if these conditions are met, the logic will act on the "SET" of the "LATCH" and the result is that the backup phase signal (R) will be used. When the return signal acts on the "RESET" of the "LATCH", the system blocks the backup phase (R) signal and uses the phase signal (A, B, C). Note that, when the bank uses the backup phase (R), the last signal on the right side is generated, which serves to block replacement in the other banks, if any. This logic can be assembled using other types of logic gates and connections, but they will follow the same reasoning and the outputs will be the same, carrying out the virtualization of the centralizing cabinet, which is the object of the present invention.

### Final remarks

It will be easily understood by one skilled in the art that modifications may be made to the present invention without departing from the concepts set out in the description above. Such modifications should be considered as included within the scope of the present invention. Consequently, the particular embodiments previously described in detail are merely illustrative and exemplary, and not limiting in terms of the scope of the present invention, to which the full extent of the accompanying claims should be given, in addition to all and any equivalents thereof.

## Claims

1. Centralizing cabinet virtualization system in single-phase transformer and/or reactor banks of digital substations, **characterized in that** it comprises at least one MU installed in the control cabinet of each phase (A, B, C) of at least one single-phase transformer and/or single-phase reactor bank.

2. System, according to claim 1, **characterized in that** it further comprises at least one protection IED and/or CPR and/or VPR for each single-phase transformer and/or single-phase reactor bank, at least one control IED and/or CPR and/or VPR for each single-phase transformer and/or single-phase reactor bank, at least one phase selector switch for each phase (A, B, C) and backup phase (R) of the at least one single-phase transformer and/or single-phase reactor bank for selecting the bus to which each phase (A, B, C) and backup phase (R) will be connected.

3. System, according to any one of claims 1 to 2, **characterized in that** it further comprises at least one processor or processing unit, wherein the processing unit comprises at least one memory that stores computer-executable information and instructions and at least one trained convolutional neural network, wherein the processing unit and/or IED and/or CPR and/or VPR and the trained convolutional neural network are configured to provide output data and/or output instructions about one or more operating conditions of at least one of the phases (A, B, C), in response to the reception of one or more messages and/or input information from each of the phases (A, B, C) and the backup phase (R), obtained from at least one MU installed in the phase control cabinet of each of the phases (A, B, C) and the backup phase (R) of the bank and transmitted to one or more IEDs and/or CPRs and/or VPRs, wherein the execution of the instructions executes one or more steps of a method of monitoring and switching of phases (A, B, C, R) of the single-phase transformer and/or single-phase reactor banks of the digital substation.

4. System, according to claim 1, **characterized in that** the method further comprises:
- At least one human-machine interface (HMI) and/or processing equipment for acquiring and presenting information/instructions;
- At least one database;
- At least one communication and data network;
- One or more sets of equipment input information; and
- One or more sets of data and/or output instructions from IEDs and/or CPRs and/or VPRs.

5. System, according to claim 1, **characterized in that**, with the installation of the MUs in the control cabinets of each phase (A, B, C), including the backup phase (R), all signals are digitized and made available on the substation process bus or network through multicast protocols such as GOOSE and SVs messages.

6. System, according to any one of claims 1 to 5, **characterized in that** all MUs of phases (A, B, C), including the backup phase (R), will publish GOOSE and SVs messages with the digitized information and the protection and/or control IEDs and/or CPRs and/or VPRs will subscribe to the messages of the respective bank and of the backup phase (R).

7. System, according to any one of claims 1 to 6, **characterized in that** the IED and/or CPR and/or VPR, in normal operating conditions, will use the GOOSE and SV messages provided by the phases (A, B, C) of the bank and, in the case of replacement of at least one faulted phase (A, B, C) by at least one backup phase (R), the IED and/or CPR and/or VPR will block the message from the replaced phase (A, B, C) and will consider the message from the backup phase (R).

8. Computer-implemented method for training a neural network for monitoring and switching faulted phases, **characterized in that** it comprises the following method steps:
(i) Providing at least one database in the form of at least one file with the ideal and/or expected historical and/or reference data for the phases (A, B, C) of each of the transformer banks and/or at least one file or database that includes the expected physical quantities for the phases (A, B, C);
(ii) Configuring a neural network to receive, as input, the input data set, wherein each training input data set corresponds to the respective historical and expected data sets, according to the at least one database in the form of at least one file with the historical data and with the ideal and/or expected reference data for the phases (A, B, C) and backup phase (R) of each of the transformer banks;
(iii) Receiving training input data;
(iv) Configuring the neural network to assign to each phase (A, B, C) and backup phase (R) at least one expected value, according to the at least one database in the form of at least one file with the ideal and/or expected reference data for the phases (A, B, C) and backup phase (R) of each of the transformer banks and/or at least one file or database that comprises the expected physical quantities for the phases (A, B, C) and backup phase (R);
(v) Configuring the trained convolutional neural network to, in response to input data representing a normal operating condition of phases (A, B, C) and backup phase (R), not generate any blocking signal for any of the circuit breakers associated with phases (A, B, C) and backup phase (R) and not generate any alarm;
(vi) Configuring the trained convolutional neural network to, in response to input data representing an abnormal operating condition of the phases (A, B, C), generate a blocking signal to the IED and/or CPR and/or VPR to block the circuit breaker associated with the faulted bank, generate an alarm and, in response, as output data, generate an instruction and/or wait for the SE operator to command the replacement of at least one faulted phase (A, B, C) by at least one backup phase (R), wherein this command can be given through SCADA (via MMS message) or through the IED (buttons and/or keys and/or HMI) and/or CPR and/or VPR and/or processing unit;
(vii) Configuring the trained convolutional neural network to remove the internal blocking signal from the IEDs and/or CPRs and/or VPRs to unlock the operation of the circuit breakers;
(viii) Configuring the trained convolutional neural network to block the use of phase (R) by other banks parallel to the bank that is using the backup phase (R); and
(ix) Producing a neural network by repeatedly training the trained convolutional neural network with each of the training data sets for each of the phases (A, B, C) and backup phase (R).

9. Method, according to claim 8, **characterized in that** a normal operating condition indicates that the transformer and/or reactor banks are operating normally with their respective phases (A, B, C) and that the backup phase (R) is not connected to the power system.

10. Method, according to claim 8 or 9, **characterized in that** a normal operating condition is a condition wherein there is no exchange of fault and/or defect messages between at least one MU of the respective bank and at least one IED and/or CPR and/or VPR.

11. Method, according to claim 8, **characterized in that** an abnormal operating condition indicates that at least one of the phases (A, B, C) of the transformer and/or reactor bank is damaged and/or inoperative and/or operating with a defect and/or has suffered an accident and that it will not be able to return to operation in a short time, requiring its replacement by at least one backup phase (R).

12. Computer-implemented faulted phase monitoring and switching method, **characterized in that** it comprises the following method steps:
I. Obtaining, by means of at least one IED and/or CPR and/or VPR, from at least one MU of at least one of the phases (A, B, C) of a transformer bank, at least one input information of at least one of the phases (A, B, C);
II. Applying to the input information, in a processing unit, a machine learning model, preferably, but without limiting the invention, in the form of a neural network, preferably a trained convolutional neural network;
III. Obtaining, in the processing unit, as a result of applying the machine learning model, at least one output information equivalent to an operating condition of at least one of the phases (A, B, C); and
IV. in case of normal operating condition, not generating any alarm signal and/or suggestion and/or switching instruction; or
V. in the event of an abnormal operating condition, generating, by means of the processing unit and/or IED and/or CPR and/or VPR, an alarm signal and an instruction in the form of a command to replace the at least one faulted phase (A, B, C) with at least one backup phase (R) from the bank;
VI. Checking, using the processing unit and/or IED and/or CPR and/or VPR, whether the corresponding bank is isolated, whether the circuit breakers are open and the bank is without voltage;
VII. Interlocking the circuit breakers, through the processing unit and/or IED and/or CPR and/or VPR, generating an internal signal to the IED and/or CPR and/or VPR to block the operation of the circuit breakers;
VIII. Sending, through the processing unit and/or IED and/or CPR and/or VPR, commands via multicast protocol to at least one MU to open the switches of each winding of the equipment that connects to the main bus of the SE and close the phase selector switches to connect the backup phase (R) to the main bus of the SE;
IX. Blocking, through the processing unit and/or IED and/or CPR and/or VPR, the information of the faulted phase (A, B, C), originating from the at least one MU, in its logic and use the information published by the at least one MU of the backup phase (R);
X. Receiving, through the processing unit and/or IED and/or CPR and/or VPR, from the at least one MU, a switching maneuver completion signal; and
XI. Deactivating, through the processing unit and/or IED and/or CPR and/or VPR, the interlocking of the circuit breakers by removing the blocking signal, releasing a command to energize the corresponding bank with the at least one backup phase (R).

13. Centralizing cabinet virtualization system in single-phase transformer and/or reactor banks of digital substations, **characterized in that** it performs at least one, preferably all, of the steps of the faulted phase monitoring and switching method defined in claim 12.

14. Computer-readable memory, **characterized in that** it comprises a set of instructions that, when executed, perform the faulted phase monitoring and switching method defined in claim 12.
